# EUROPEAN PATENT APPLICATION

(11) **EP 2 023 498 A2**
(43) Date of publication of application: **11.02.2009**
(21) Application number: 08010480.5
(22) Date of filing: 09.06.2008
(51) Int. Cl.: H04B 1/38

(54) **Wireless communication apparatus**

(30) Priority: 06.08.2007 JP 2007204207
(71) Applicant: ALPS ELECTRIC CO., LTD., Tokyo 145-8501 (JP)
(72) Inventor: Miyaura, Masao, Ota-ku Tokyo 145-8501 (JP); Ota, Kazuto, Ota-ku Tokyo 145-8501 (JP)
(74) Representative: Klunker . Schmitt-Nilson . Hirsch

(57) **Abstract**

A wireless communication apparatus includes a wiring board (1) on which an electronic circuit (2) is provided, and a built-in antenna (3) and an RF module (4) mounted on the wiring board. An antenna terminal (8), and first terminals (9) and second terminals (10), which are selectively connected to the electronic circuit, are arranged on the periphery of the RF module. The second terminals are arranged at positions obtained by displaying the first terminals along the periphery of the RF module by a predetermined amount. Either the state where the first terminals are connected to the electronic circuit and the antenna terminal is connected to a power feeding line (5) or the state where the second terminals are connected to the electronic circuit and the antenna terminal is connected to a power feeding line (6) is selectable by rotating the RF module on the wiring board by 90 degrees.

## Description

### BACKGROUND OF THE INVENTION

### 1. Field of the Invention

The present invention relates to wireless communication apparatuses that perform transmission and reception by connecting a radio-frequency (RF) module mounted on a wiring board to a built-in antenna or an external antenna.

### 2. Description of the Related Art

On-vehicle wireless communication apparatuses that can be used in, for example, an automatic fare collection system (so-called "Electronic Toll Collection System" or ETC) are available in the related art. Some of these wireless communication apparatuses have a structure in which an RF module with a receiver section and a transmitter section is mounted on a wiring board (motherboard) on which an electronic circuit including a controller such as a central processing unit (CPU) is provided, and the RF module is electrically connected to the electronic circuit. Further, an antenna terminal of the RF module is connected to a built-in antenna or an external antenna. In these wireless communication apparatuses, when the built-in antenna, such as a chip antenna provided near the RF module on the wiring board, or the external antenna connected to the RF module via a signal cable such as a coaxial cable receives an external signal, the received signal is supplied to the receiver section of the RF module, and the receiver section detects reception information. A transmission signal supplied from the transmitter section of the RF module to the built-in antenna or the external antenna is transmitted to the outside from the antenna.

In this type of wireless communication apparatuses, the antenna terminal and groups of terminals for connecting to the electronic circuit are provided on the periphery of the RF module. These groups of terminals are soldered to corresponding wiring patterns on the wiring board and are connected to the electronic circuit on the wiring board. The antenna terminal of the RF module is connected to the built-in antenna or the external antenna via a power feeding line on the wiring board. In order to connect the RF module to the built-in antenna, it is preferable that the antenna terminal of the RF module be directed to an area where the built-in antenna is disposed. In contrast, in order to connect the RF module to the signal cable of the external antenna, it is preferable that the antenna terminal of the RF module be directed to an edge of the wiring board so that an end portion (connector portion) of the signal cable can be easily attached and detached. Therefore, two types of wiring boards with different layouts of power feeding lines and wiring patterns connected to the RF module are generally prepared depending on whether the wireless communication apparatus uses the built-in antenna or the external antenna.

However, the wiring boards have the same basic structure regardless of whether the RF module on the wiring board is connected to the built-in antenna or the external antenna. It is thus inefficient to prepare and selectively use two types of wiring boards depending on whether the built-in antenna or the external antenna is used, resulting in an increase in the cost of the wireless communication apparatus. For example, a proposal has been made in Japanese Unexamined Patent Application Publication No. 2002-353841 for a wireless communication apparatus with a selectable switch provided between an antenna terminal of an RF module and a built-in antenna, thereby enabling one wireless board to be commonly used in cases where either the built-in antenna or an external antenna is used. That is, in the foregoing wireless communication apparatus in the related art, the selectable switch is mounted on a power feeding line provided between the RF module and the built-in antenna on the wiring board. In a normal state, the RF module is connected to the built-in antenna. When an end portion of a signal cable of the external antenna is inserted into the selectable switch, the connection between the RF module and the built-in antenna is broken, and the RF module is in turn connected to the external antenna.

In the wireless communication apparatus in the related art described in Japanese Unexamined Patent Application Publication No. 2002-353841, since the selectable switch is mounted on the wiring board, the common wiring board can be used when either of the built-in antenna and the external antenna is used. When the selectable switch is additionally provided, the cost of parts is undesirably increased. It is also necessary to make sure that there is a sufficient extra space for mounting the selectable switch on the wiring board. As a result, the wiring board tends to increase in size.

### SUMMARY OF THE INVENTION

The present invention provides a wireless communication apparatus which has a common wiring board for use in cases where either a built-in antenna or an external antenna is used, which requires no additional special parts, and whose cost can be easily reduced.

According to an aspect of the present invention, there is provided a wireless communication apparatus including a wiring board on which an electronic circuit is provided; an RF module mounted on the wiring board; an antenna terminal connectable to an antenna, the antenna terminal being provided on a periphery of the RF module; and a group of first terminals and a group of second terminals that are selectively connected the electronic circuit, the group of first terminals and the group of second terminals being provided along the periphery of the RF module, the group of second terminals being arranged at positions obtained by displacing the group of first terminals by a predetermined amount along the periphery of the RF module. In a case where the RF module is mounted on the wiring board in a state where the group of first terminals are connected to the electronic circuit, the antenna terminal is disposed at a position at which the antenna terminal can be connected to a built-in antenna on the wiring board. In a case where the RF module is mounted on the wiring board in a state where the group of second terminals are connected to the electronic circuit, the antenna terminal is disposed at a position at which the antenna terminal can be connected to an external antenna.

In the wireless communication apparatus having the foregoing structure, the RF module can be connected to the built-in antenna or the external antenna depending on on which position each of the terminals of the RF module is provided on the wiring board. That is, when the group of first terminals of the RF module are arranged at positions at which the group of first terminals can be connected to wiring patterns on the wiring board, the antenna terminal of the RF module is disposed at a position at which the antenna terminal can be connected to the built-in antenna. Therefore, the RF module can be connected to the electronic circuit and the built-in antenna, thereby enabling transmission and reception using the built-in antenna. When the RF module is displaced on the wiring board so that the group of second terminals are arranged at positions where the group of first terminals used to be located, the antenna terminal is disposed at a position at which the antenna terminal can be connected to the external antenna. Therefore, the RF module can be connected to the electronic circuit and the external antenna, enabling transmission and reception using the external antenna. Therefore, one common wiring board can be used when either the built-in antenna or the external antenna is used, and it becomes unnecessary to provide additional special parts, such as a selectable switch, for using the common wiring board. The wireless communication apparatus that can easily satisfy different specifications can be manufactured at a low cost.

In the wireless communication apparatus with the foregoing structure, an outer shape of the RF module may preferably be regular polygonal in plan view, and the group of first terminals and the group of second terminals may preferably be selectively connected to the electronic circuit by rotating the RF module on the wiring board by a predetermined angle. In such a case, the common wiring board can be used without increasing the size thereof. That is, if the outer shape of the RF module is regular polygonal in plan view with n sides (n is an integer greater than or equal to 3), the RF module is always mounted at the same position even when the RF module is rotated on the wiring board by degrees of an integer multiple of (360/n). One of two mounting positions of the RF module (for the built-in antenna and the external antenna) can be selected without adding an extra mounting area to the wiring board. For example, when the outer shape of the RF module is square in plan view (n = 4), the mounting position at which the RF module can be connected to the built-in antenna or the mounting position at which the RF module can be connected to the external antenna is selected by rotating the RF module on the wiring board by 90 degrees (or 180 degrees). The area where the RF module is mounted on the wiring board does not change when either mounting position is selected. It thus becomes unnecessary to add an extra mounting space to the wiring board. Further, when the outer shape of the RF module is square in plan view, no adverse effects are expected on design and manufacture of the RF module.

In the wireless communication apparatus with the foregoing structure, the outer shape of the RF module may be rectangular in plan view, and the group of first terminals and the group of second terminals may be selectively connected to the electronic circuit by rotating the RF module on the wiring board by 180 degrees. With this structure, the area where the RF module is mounted on the wiring board does not change when either the mounting position at which the RF module can be connected to the built-in antenna or the mounting position at which the RF module can be connected to the external antenna is selected. It thus becomes unnecessary to add an extra mounting space to the wiring board, and the wiring board can be commonly used without increasing the size thereof. Further, it becomes unnecessary to add special parts in order to use the common wiring board. Since it is unnecessary to form a special outer shape of the RF module, no adverse effects are expected on design and manufacture of the RF module.

In the wireless communication apparatus with the foregoing structure, the group of first terminals and the group of second terminals may be selectively connected to the electronic circuit by sliding the RF module on the wiring board by a predetermined amount. In this case, the area where the RF module is mounted on the wiring board is slightly different depending on whether the built-in antenna or the external antenna is used. Therefore, the wiring board needs to have an extra space in which the RF module is not mounted.

### BRIEF DESCRIPTION OF THE DRAWINGS

Fig. 1 is a schematic plan view of a wireless communication apparatus according to a first exemplary embodiment of the present invention;
Fig. 2 is a block diagram of an internal structure of an RF module used in the wireless communication apparatus;
Fig. 3 is a schematic plan view of another application of the wireless communication apparatus according to the first exemplary embodiment;
Fig. 4 is a schematic plan view of a wireless communication apparatus according to a second exemplary embodiment of the present invention;
Fig. 5 is a schematic plan view of another application of the wireless communication apparatus according to the second exemplary embodiment;
Fig. 6 is a schematic plan view of a wireless communication apparatus according to a third exemplary embodiment of the present invention; and
Fig. 7 is a schematic plan view of another application of the wireless communication apparatus according to the third exemplary embodiment.

### DESCRIPTION OF THE PREFERRED EMBODIMENTS

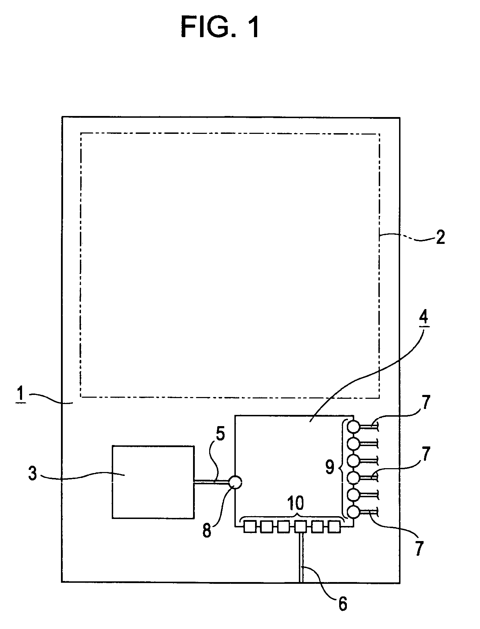

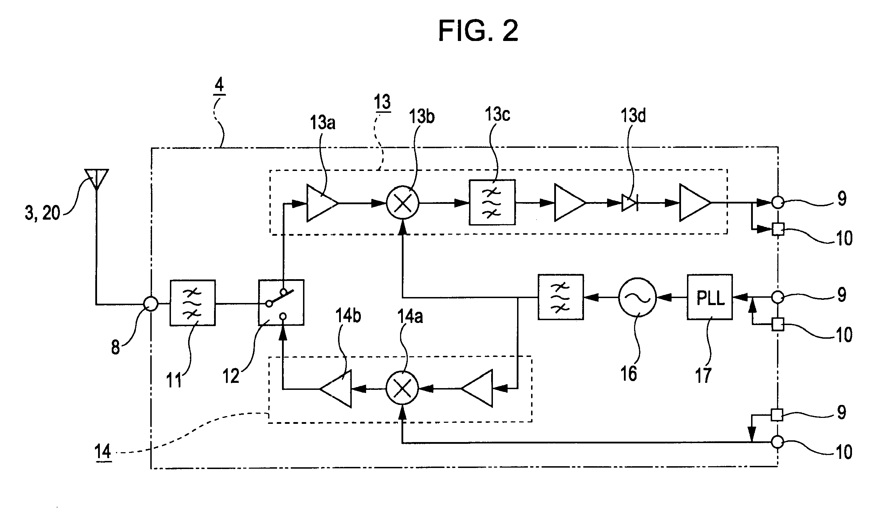

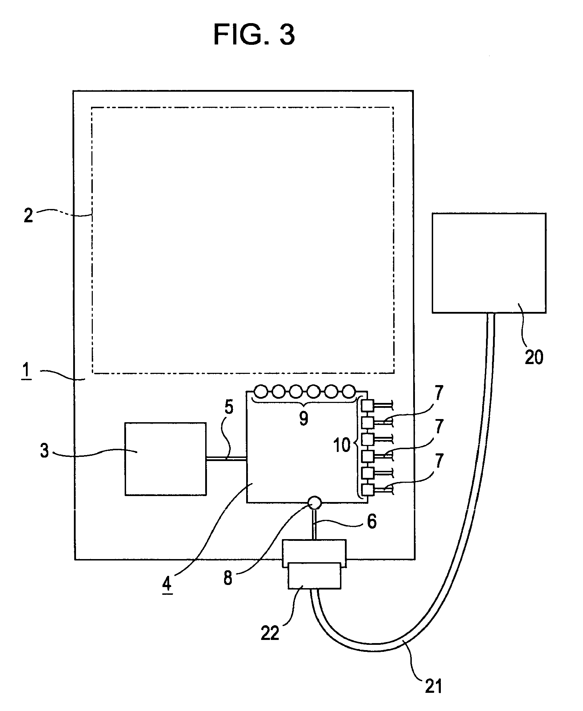

Preferred embodiments of the present invention will be described with reference to the drawings. Fig. 1 is a schematic plan view of a wireless communication apparatus according to a first exemplary embodiment of the present invention. Fig. 2 is a block diagram of an internal structure of an RF module used in the wireless communication apparatus. Fig. 3 is a schematic plan view of another application of the wireless communication apparatus

The wireless communication apparatus shown in Fig. 1 has a schematic structure including a wiring board (motherboard) 1 on which an electronic circuit 2 including a controller such as a CPU is provided, and a built-in antenna 3 and an RF module 4 mounted on the wiring board 1. The wiring board 1 is a multilayer board. Power feeding lines 5 and 6 and numerous wiring patterns 7 are formed on the top face of the wiring board 1. The built-in antenna 3 is formed of a chip antenna (e.g., a patch antenna) mounted on the wiring board 1. Alternatively, the built-in antenna 3 may be formed of, for example, a pattern antenna patterned on the wiring board 1. The outer shape of the RF module 4 is square in plan view. The RF module 4 is covered with a shield casing (not shown). An antenna terminal 8, a group of first terminals 9, a group of second terminals 10, and a group of dummy terminals (not shown) are arranged on the periphery of the RF module 4.

Each of the terminals of the RF module 4 will now be described. With continued reference to Fig. 1, the antenna terminal 8 is provided at substantially the center of the left side of the RF module 4 and faces the built-in antenna 3 on the wiring board 1. Since the antenna terminal 8 is soldered to the power feeding line 5, the RF module 4 is connected to the built-in antenna 3 via the power feeding line 5. The group of first terminals 9 are arranged along the right side of the RF module 4. Since the group of first terminals 9 are individually soldered to the corresponding wiring patterns 7, the RF module 4 is connected to the electronic circuit 2 via the wiring patterns 7. The group of second terminals 10 are arranged along the bottom side of the RF module 4 in Fig. 1. In order to strengthen the attachment of the RF module 4, the group of second terminals 10 are soldered to lands (not shown) on the wiring board 1. However, in the state shown in Fig. 1, the group of second terminals 10 make no electrical contribution. Similarly, the group of dummy terminals (not shown) are soldered to lands (not shown) on the wiring board 1 in order to strengthen the attachment of the RF module 4. Similarly, the group of dummy terminals make no electrical contribution. In Fig. 1, the power feeding line 6 on the wiring board 1 overlaps a substantially center portion of the bottom side of the RF module 4, but makes no electrical contribution.

Referring now to the block diagram shown in Fig. 2, the RF module 4 contains a band-pass filter 11 connected to the antenna terminal 8, a transmission/reception switch 12, a receiver section 13, a transmitter section 14, a local oscillator 16, and a phase-locked loop (PLL) circuit 17. When the RF module 4 is in a standby mode waiting for a reception signal, the band-pass filter 11 is connected to the receiver section 13 by the transmission/reception switch 12. An external signal received by the built-in antenna 3 connected to the antenna terminal 8 is supplied to the receiver section 13 via the band-pass filter 11. This reception signal is amplified by a low-noise amplifier 13a in the receiver section 13. Together with a local oscillation signal output from the local oscillator 16, the amplified signal is input to a mixer 13b. The mixer 13b outputs an intermediate frequency (IF) signal which has a frequency-converted differential frequency. The IF signal output from the mixer 13b is input via a band-pass filter 13c at the subsequent stage of the mixer 13b to a reception detector 13d. The reception detector 13d detects an ASK demodulation signal, which is supplied via the wiring patterns 7 to and processed by the controller in the electronic circuit 2. In order to transmit a signal, the band-pass filter 11 is connected to the transmitter section 14 by the transmission/reception switch 12. The controller in the electronic circuit 2 supplies an ASK modulation signal as a transmission signal to a modulator 14a in the transmitter section 14. The transmission signal is amplified by a power amplifier 14b. The amplified signal is supplied to the built-in antenna 3 via the band-pass filter 11 so that the signal can be transmitted to the outside. The oscillation frequency of the local oscillator 16 is set by the PLL circuit 17. The PLL circuit 17 is under control of the controller in the electronic circuit 2.

As shown in the simplified diagram in Fig. 2, the RF module 4 is provided with two groups of terminals connected to the electronic circuit 2. Each group of terminals has the same function. One of the two groups serves as the group of first terminals 9, and the other serves as the group of second terminals 10. In the exemplary application shown in Fig. 1, the group of first terminals 9 are soldered to the corresponding wiring patterns 7 in an overlapping fashion. Therefore, in the RF module 4, the group of first terminals 9 are connected to the electronic circuit 2, and the group of second terminals 10 make no electrical contribution. In the exemplary application shown in Fig. 1, the antenna terminal 8 of the RF module 4 is soldered to the power feeding line 5 in an overlapping fashion. Therefore, the RF module 4 is connected to the built-in antenna 3, and the power feeding line 6 makes no electrical contribution.

When the mounting position of the RF module 4 on the wiring board 1 is changed to that shown in Fig. 3, the group of second terminals 10 are arranged at positions where the group of first terminals 9 used to be located in Fig. 1. Further, the antenna terminal 8 is disposed at a position overlapping the power feeding line 6. That is, when the RF module 4 shown in Fig. 1 is rotated counterclockwise by 90 degrees, the group of first terminals 9 are arranged along the top side as shown in Fig. 3, and the group of second terminals 10 are arranged along the right side shown in Fig. 3. Therefore, the group of second terminals 10 can be soldered to the corresponding wiring patterns 7 in an overlapping fashion, and the antenna terminal 8 disposed at substantially the center of the bottom side of the RF module 4 is soldered to the power feeding line 6. The power feeding line 6 is to connect to a coaxial cable 21 of an independent external antenna 20. As shown in Fig. 3, the external antenna 20 can be electrically connected to the power feeding line 6 by attaching a connector section 22 of the coaxial cable 21 to the bottom periphery of the wiring board 1 as shown in Fig. 3.

Therefore, in the exemplary application shown in Fig. 3, the RF module 4 is in a state where the group of second terminals 10 are connected to the electronic circuit 2, and the antenna terminal 8 is connected to the power feeding line 6. In this state, the group of first terminals 9 and the power feeding line 5 for the built-in antenna 3 make no electrical contribution. Even when the mounting position of the RF module 4 changes from the state shown in Fig. 1 to the state shown in Fig. 3, there is no change in the area where the RF module 4 is mounted on the wiring board 1.

As has been described above, in the wireless communication apparatus according to the first exemplary embodiment, the RF module 4 is connectable to the built-in antenna 3 or the external antenna 20 according to the arrangement of the antenna terminal 8, the group of first terminals 9, and the group of second terminals 10 of the RF module 4 on the wiring board 1. That is, as shown in Fig. 1, when the group of first terminals 9 are arranged at positions at which the group of first terminals 9 can be connected to the corresponding wiring patterns 7, the antenna terminal 8 is disposed at a position at which the antenna terminal 8 can be connected to the built-in antenna 3. Therefore, the RF module 4 can be connected to the electronic circuit 2 and the built-in antenna 3, enabling transmission and reception using the built-in antenna 3. In contrast, when the mounting position of the RF module 4 on the wiring board 1 is changed to that shown in Fig. 3, that is, when the group of second terminals 10 are arranged at positions at which the group of second terminals 10 can be connected to the corresponding wiring patterns 7, the antenna terminal 8 is disposed at a position at which the antenna terminal 8 can be connected to the power feeding line 6. Therefore, the RF module 4 can be connected to the electronic circuit 2 and the external antenna 20, enabling transmission and reception using the external antenna 20. When either of the built-in antenna 3 and the external antenna 20 is used, the wiring board 1 can be commonly used. Further, it becomes unnecessary to add special parts in order to enable the wiring board 1 to be commonly used in both cases where the built-in antenna 3 or the external antenna 20 is used. The wireless communication apparatus that can easily satisfy different specifications can be manufactured at a low cost.

In the first exemplary embodiment, the outer shape of the RF module 4 is square. By rotating the RF module 4 by 90 degrees on the wiring board 1, either the mounting position at which the RF module 4 can be connected to the built-in antenna 3 or the mounting position at which the RF module 4 can be connected to the external antenna 20 can be selected. When either mounting position is selected, the area where the RF module 4 is mounted on the wiring board 1 does not change. It thus becomes unnecessary to add an additional mounting area to the wiring board 1, thus avoiding an increase in the size of the wiring board 1.

In the first exemplary embodiment, either the mounting position at which the RF module 4 can be connected to the built-in antenna 3 or the mounting position at which the RF module 4 can be connected to the external antenna 20 can be selected by rotating the RF module 4 on the wiring board 1 by 90 degrees. When the group of first terminals 9 and the group of second terminals 10 are arranged axisymmetrically or when the power feeding lines 5 and 6 are arranged axisymmetrically, one of the two mounting positions for a built-in antenna and an external antenna can be selected by rotating the RF module 4 on the wiring board 1 by 180 degrees.

In the first exemplary embodiment, the group of first terminals 9 are arranged along one side of the periphery of the RF module 4, and the group of second terminals 10 are arranged along another side of the periphery of the RF module 4. Alternatively, another terminal layout in which the group of first terminals 9 and the group of second terminals 10 are arranged in a dispersed manner along a plurality of sides of the periphery of the RF module 4 can be used. Alternatively, another terminal layout in which the group of first terminals 9 and the group of second terminals 10 are arranged along one and the same side of the periphery of the RF module 4 may be used.

Further, when the outer shape (in plan view) of the RF module 4 is regular polygonal other than square, substantially the same advantages as those achieved in the first exemplary embodiment can be achieved by rotating the RF module 4 on the wiring board 1 by a predetermined angle. That is, if the outer shape of the RF module 4 is regular polygonal with n sides (n is an integer greater than or equal to 3), the RF module 4 is always mounted at the same position even when the RF module 4 is rotated on the wiring board 1 by degrees of an integer multiple of (360/n). One of the two mounting positions of the RF module 4 (for a built in antenna and an external antenna) can be selected without adding an extra mounting area to the wiring board 1. Yet, it is preferable that the outer shape of the RF module 4 be square in plan view, as in the first exemplary embodiment, since no adverse effects are expected on design and manufacture of the RF module 4.

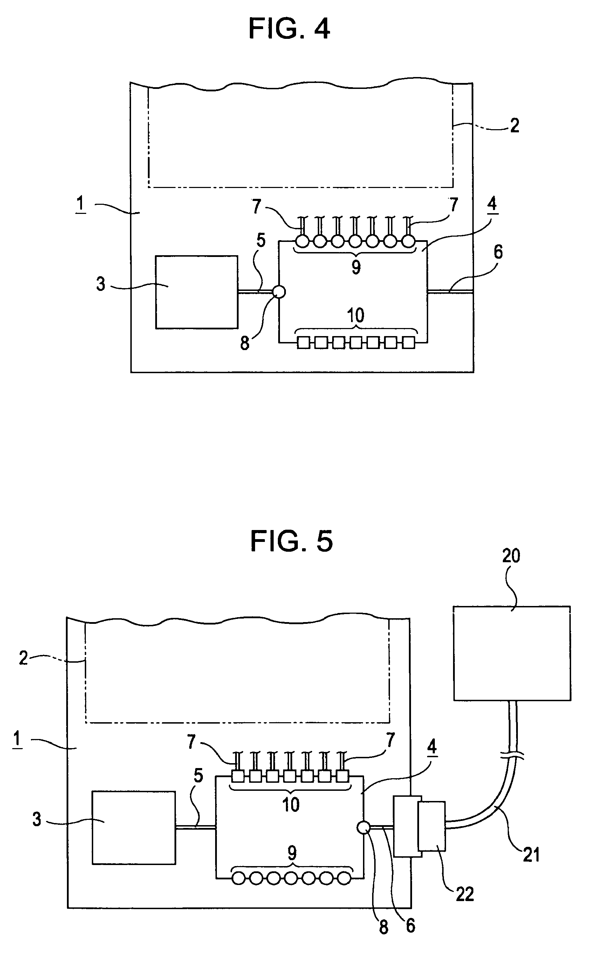

Fig. 4 is a schematic plan view of a wireless communication apparatus according to a second exemplary embodiment of the present invention. Fig. 5 is a schematic plan view of another application of the wireless communication apparatus. Since parts corresponding to those shown in Figs. 1 and 3 are given the same reference numerals, descriptions thereof are omitted to avoid redundancy.

As shown in Figs. 4 and 5, in the wireless communication apparatus according to the second exemplary embodiment, the outer shape of the RF module 4 is rectangular in plan view. The group of first terminals 9 are arranged along one of two long sides of the periphery of the RF module 4, and the group of second terminals 10 are arranged along the other long side of the periphery of the RF module 4. The power feeding line 6 for the external antenna 20 is disposed axisymmetrically to the power feeding line 5 for the built-in antenna 3 with the mounting area of the RF module 4 provided therebetween. When the RF module 4 is mounted on the wiring board 1 at the position shown in Fig. 4, the group of first terminals 9 overlap the corresponding wiring patterns 7, and the antenna terminal 8 overlaps the power feeding line 5. Therefore, the RF module 4 can be connected to the electronic circuit 2 and the built-in antenna 3, enabling transmission and reception using the built-in antenna 3. In contrast, when the mounting position of the RF module 4 on the wiring board 1 is rotated by 180 degrees as shown in Fig. 5, the group of second terminals 10 are arranged at positions where the group of first terminals 9 used to be located in Fig. 4. Further, the antenna terminal 8 is disposed at a position overlapping the power feeding line 6. Therefore, the RF module 4 can be connected to the electronic circuit 2 and the external antenna 20, enabling transmission and reception using the external antenna 20.

In the second exemplary embodiment, the area where the RF module 4 is mounted on the wiring board 1 does not change when either the mounting position at which the RF module 4 can be connected to the built-in antenna 3 or the mounting position at which the RF module 4 can be connected to the external antenna 20 is selected. It thus becomes unnecessary to add an extra mounting area to the wiring board 1, thus enabling common use of the wiring board 1 without increasing the size of the wiring board 1. It also becomes unnecessary to add special parts in order to enable the wiring board 1 to be commonly used. Since it is unnecessary to form a special outer shape of the RF module 4, no adverse effects are expected on design and manufacture of the RF module 4.

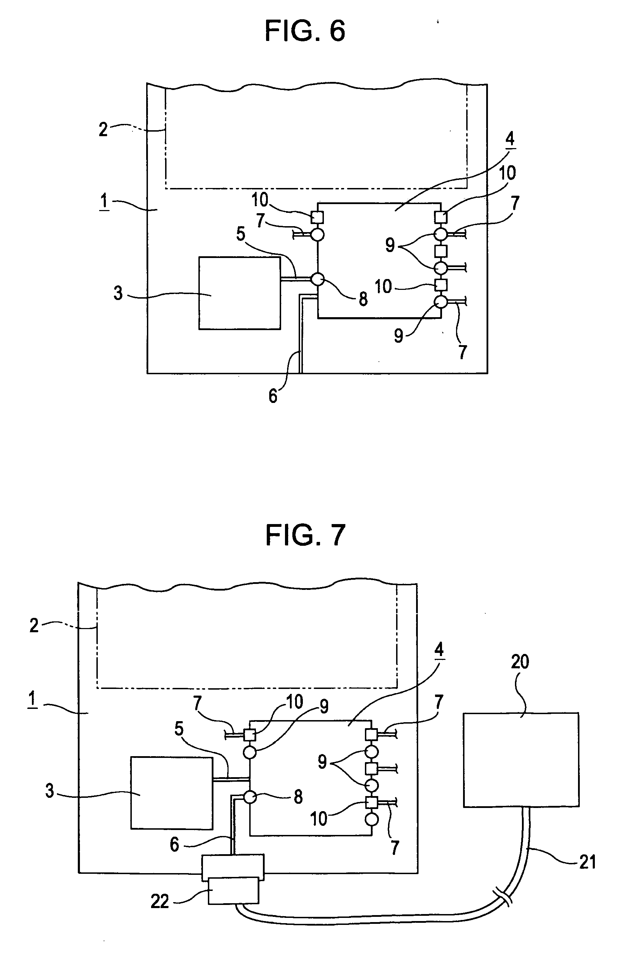

Fig. 6 is a schematic plan view of a wireless communication apparatus according to a third exemplary embodiment of the present invention. Fig. 7 is a schematic plan view of another application of the wireless communication apparatus. Since parts corresponding to those shown in Figs. 1 and 3 are given the same reference numerals, descriptions thereof are omitted to avoid redundancy.

As shown in Figs. 6 and 7, in the wireless communication apparatus according to the third exemplary embodiment, the group of first terminals 9 and the group of second terminals 10 are selectively connected to the electronic circuit 2 by sliding the RF module 4 on the wiring board 1 by a predetermined amount. Further, the power feeding line 5 and the power feeding line 6 are arranged on the wiring board 1 side by side at a distance of this predetermined amount from each other. That is, when the RF module 4 is mounted on the wiring board 1 at the position shown in Fig. 6, the group of first terminals 9 overlap the corresponding wiring patterns 7, and the antenna terminal 8 overlaps the power feeding line 5. Therefore, the RF module 4 can be connected to the electronic circuit 2 and the built-in antenna 3, enabling transmission and reception using the built-in antenna 3. In contrast, when the RF module 4 shown in Fig. 6 is slid downward in Fig. 6 by the predetermined amount, as shown in Fig. 7, the group of second terminals 10 are arranged at positions where the group of first terminals 9 used to be located in Fig. 6. Further, the antenna terminal 8 is disposed at a position overlapping the power feeding line 6. Therefore, the RF module 4 can be connected to the electronic circuit 2 and the external antenna 20, enabling transmission and reception using the external antenna 20.

Even in the third exemplary embodiment, the wiring board 1 can be commonly used in both cases where the built-in antenna 3 or the external antenna 20 is used without requiring additional special parts. In the third exemplary embodiment, the area where the RF module 4 is mounted on the wiring board 1 is slightly different depending on whether the built-in antenna 3 or the external antenna 20 is used. Therefore, the wiring board 1 needs to have an extra space in which the RF module 4 is not mounted.

## Claims

1. A wireless communication apparatus comprising:
a wiring board (1) on which an electronic circuit (2) is provided;
a radio frequency module (4) mounted on the wiring board (1) ;
an antenna terminal (8) connectable to an antenna, the antenna terminal (8) being provided on a periphery of the radio frequency module (4); and
a group of first terminals (9) and a group of second terminals (10) that are selectively connected to the electronic circuit (2) and that are provided along the periphery of the radio frequency module (4), the group of second terminals (10) being arranged at positions obtained by displacing the group of first terminals (9) by a predetermined amount along the periphery of the radio frequency module (4),
wherein, in a case where the radio frequency module (4) is mounted on the wiring board (1) in a state where the group of first terminals (9) are connected to the electronic circuit (2), the antenna terminal (8) is disposed at a position at which the antenna terminal (8) can be connected to a built-in antenna (3) on the wiring board (1), and, in a case where the radio frequency module (4) is mounted on the wiring board (1) in a state where the group of second terminals (10) are connected to the electronic circuit (2), the antenna terminal (8) is disposed at a position at which the antenna terminal (8) can be connected to an external antenna (20).

2. The wireless communication apparatus according to Claim 1, wherein an outer shape of the radio frequency module (4) is regular polygonal in plan view, and the group of first terminals (9) and the group of second terminals (10) are selectively connected to the electronic circuit (2) by rotating the radio frequency module (4) on the wiring board (1) by a predetermined angle.

3. The wireless communication apparatus according to Claim 2, wherein the outer shape of the radio frequency module (4) is square in plan view.

4. The wireless communication apparatus according to Claim 1, wherein an outer shape of the radio frequency module (4) is rectangular in plan view, and the group of first terminals (9) and the group of second terminals (10) are selectively connected to the electronic circuit (2) by rotating the radio frequency module (4) on the wiring board (1) by 180 degrees.

5. The wireless communication apparatus according to one of Claims 1-4, wherein the group of first terminals (9) and the group of second terminals (10) are selectively connected to the electronic circuit (2) by sliding the radio frequency module (4) on the wiring board (1) by a predetermined amount.
